# EUROPEAN PATENT SPECIFICATION

(11) **EP 0 484 320 B1**
(45) Date of publication and mention of the grant of the patent: **28.04.1999**
(21) Application number: 92100517.9
(22) Date of filing: 03.10.1986
(51) Int. Cl.: H05K 7/20, H01L 23/46, H01L 23/473

(54) **Cooling modules for electronic circuit devices**
Kühlmodule für Vorrichtungen mit elektronischem Schaltkreis
Modules de refroidissement pour dispositifs de circuit électronique

(30) Priority: 19.11.1985 JP 259284/85; 28.01.1986 JP 17031/86
(43) Date of publication of application: 06.05.1992
(62) Divisional of application: 86307669.1
(73) Proprietor: FUJITSU LIMITED, Kawasaki-shi, Kanagawa 211 (JP)
(72) Inventor: Yamamoto, Haruhiko, Yokohama-shi, Kanagawa 222 (JP); Suzuki, Masahiro, Inagi-shi, Tokyo 206 (JP); Udagawa, Yoshiaki, Tokyo 155 (JP); Nakata, Mitsuhiko, Kawasaki-shi, Kanagawa 214 (JP); Katsuyama, Koji, Yokohama-shi, Kanagawa 241 (JP)
(74) Representative: Fane, Christopher Robin King

(56) References cited:
- EP-A- 0 151 068
- IBM TECHNICAL DISCLOSURE BULLETIN, vol.20, no.10, March 1978, NY,US pages 3898 - 3899
- IBM TECHNICAL DISCLOSURE BULLETIN, vol.21, no.6, November 1978, NY,US page 2438

## Description

The present invention relates to cooling modules for electronic circuit devices.

A printed circuit board holding electronic circuit components, such as semiconductors, large scale integrated circuits (LSI's), or integrated circuit (IC's) may be cooled by a series of cooling modules which are operable to remove the heat dissipated from the components.

Fujitsu Limited's prior European patent application published under the number EP-A-0151068, disclosed a cooling module, in combination with an electronic circuit component mounted on a printed circuit board, including a heat transfer body, for conducting heat from the electronic circuit component to a coolant in the module, resilient biasing means connected to the heat transfer body and serving to urge that body towards the circuit component, and passage means for containing the coolant which flows in contact with a main face of the heat transfer body.

It is desirable to improve the efficiency of heat transfer in such a cooling module.

IBM Technical Disclosure Bulletin, Vol 20, No. 10, pp3898-3899 discloses a cooling module, in combination with an electronic circuit component mounted on a printed circuit board, including: a heat transfer plate, for conducting heat from the electronic circuit component to a coolant in the module, having a substantially cylindrical tubular construction provided thereon and projecting axially from the main face thereof; resilient biasing means connected to the heat transfer plate and serving to urge that plate towards the circuit component, the substantially cylindrical tubular construction extending within the resilient biasing means; and passage means for containing the coolant which flows in contact with a main face of the heat transfer plate.

According to the present invention there is provided a cooling module, in combination with an electronic circuit component mounted on a printed circuit board, including:
a heat transfer plate, for conducting heat from the electronic circuit component to a coolant in the module, having a substantially cylindrical tubular construction provided thereon and projecting axially from the main face thereof;
resilient biasing means connected to the heat transfer plate and serving to urge that plate towards the circuit component, the substantially cylindrical tubular construction extending within the resilient biasing means; and
passage means for containing the coolant which flows in contact with a main face of the heat transfer plate,
**characterised in that** the passage means comprises a nozzle, the outlet of which is within the substantially cylindrical tubular construction and directed towards the main face of the heat transfer plate such that, when the module is in use, the coolant flows to a major portion of the main face by way of the tubular construction.

The tubular construction may be a substantially cylindrical tube, which may be made of corrugated material. It may also be provided with internally projecting heat transfer fins.

In one embodiment, the substantially cylindrical tubular construction is formed of a plurality of heat-transfer fins which are spaced apart from one another around the axis of that construction.

Reference will now be made, by way of example, to the accompanying drawings, in which:
Fig. 1 is a schematic axial sectional view of a first electronic circuit device not embodying the present invention;
Fig. 2 is a schematic axial sectional view of an assembly of devices similar to Fig. 1;
Fig. 3 is a diagrammatic perspective view of the assembly shown in Fig. 2;
Fig. 4 is an axial sectional view of an electronic circuit device embodying the present invention;
Fig. 5 is a plan view of part of the device of Fig. 4, but showing a variant thereof;
Fig. 6 is an axial sectional view of that part of the device of Fig. 4 which is shown in Fig. 5, but showing another modification thereof;
Fig. 7 is an axial sectional view of another electronic circuit device embodying the present invention;
Fig. 8 is a sectional view taken along the line VIII-VIII in Fig. 7;
Fig. 9 is a sectional view showing a variant of Fig. 8;

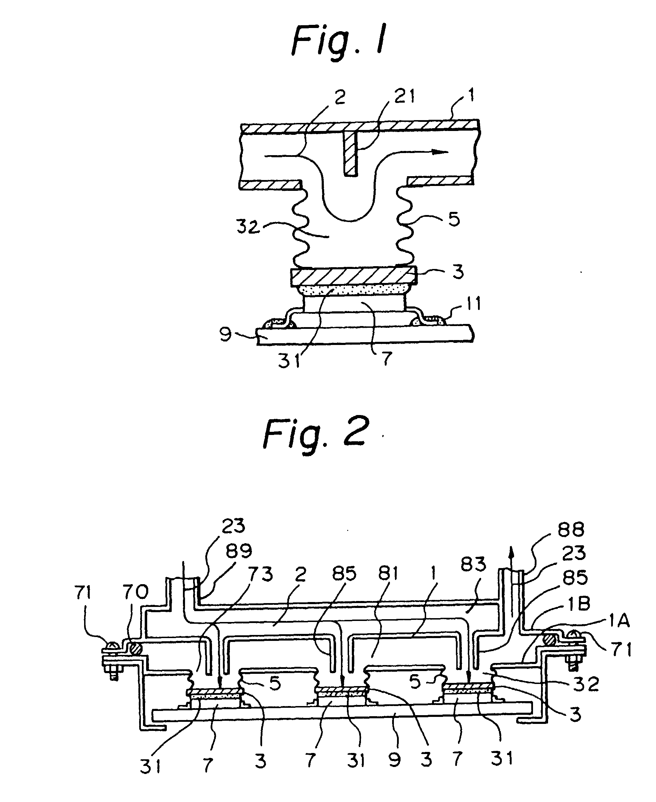

Figure 1 shows an electronic circuit device, not embodying the present invention, including a cooling module having a passage 1 for coolant flow.

The coolant can be gas but it is not limited thereto, or may be a liquid, such as water, liquid fluorocarbon, or even a liquid metal such as mercury or gallium. The passage 1 may be a part of a recirculation line having a pump and a heat radiator or heat exchanger.

A heat transfer plate 3 which is made of, for example, a heat conductive material such as copper or brass, is connected to the passage 1 by means of a bellows 5 attached to the passage 1. The heat transfer plate 3 may be made of a metal having a high solder wetting property. The bellows 5 may be made of a thin sheet of copper or stainless steel. The passage 1 has a deflector 21 extending towards the heat transfer plate 3. A coolant circulation zone 32 is defined in the bellows 5, in which zone 32 the heat transfer plate 3 is exposed to the coolant at one main face of the plate 3.

The direction of the coolant flow in the passage 1 is changed by the deflector 21, and heat is removed from the heat transfer plate 3 in the circulation zone 32.

The plate 3 is urged resiliently towards an electronic circuit component 7, such as a semiconductor IC or LSI, provided on a printed circuit board 9, by means of the bellows 5 and the hydraulic pressure of the coolant.

The component 7 is bonded to the printed circuit board 9 by, for example, solder 11.

In the device of Figure 1, an intermediate layer of solder 31 is provided between the heat transfer plate 3 and the circuit component 7. The intermediate layer 31 is secured to the bottom face of the heat transfer plate 3. Alternatively, the intermediate layer 31 can be secured to the circuit component 7 on the printed circuit board 9.

The solder 31 maintains its original sheet-like shape at a normal temperature, i.e. when the circuit device is not in operation. When the circuit device is operated, and consequently produces heat, the solder 31 is melted so that the heat transfer plate 3 and the circuit component 7 are joined by the solder 31. Thus, the plate 3 and component 7 can be connected to each other in a substantially complete face-to-face fashion, regardless of any unevenness of the contacting surfaces thereof.

Thus, cooling efficiency of the cooling module can be high, because the second solder 31 ensures a thermal connection between the heat transfer plate 3 and the circuit component 7.

Figure 2 shows an assembly of cooling modules similar in principle to that of Figure 1, in which the passage 1 comprises a lower half 1A and an upper half 1B. The lower half 1A has, for example, a generally U-shaped cross section, and has openings 73 connected to the recirculation zones 32 of the cooling modules. The upper half 1B can be fitted onto the lower half 1A to define an outlet passage 81.

The upper half 1B, therefore, acts as a cover of the passageway for the coolant 2. The upper half 1B has an upper inlet passage 83 which corresponds to the passage 1 in Fig. 1. The passage 83 is connected to the outlet passage 81 by nozzles 85, so that the coolant 2 fed through a recirculation line is fed or ejected towards the respective opposing main faces of the heat transfer plates 3 of the cooling modules through the nozzles 85, and is returned to the recirculation line through the outlet passage 81 and an outlet pipe 88 provided on the upper half 1B of the passage 1. The coolant 2 can be introduced into the inlet passage 83 from an inlet pipe 89 provided on the upper half 1B.

The upper half 1B can be detachably connected to the lower half by, for example, bolts 71.

The numeral 70 designates a seal, such as a ring packing or a gasket, which is located between the upper and lower halves 1A and 1B to seal the connection therebetween.

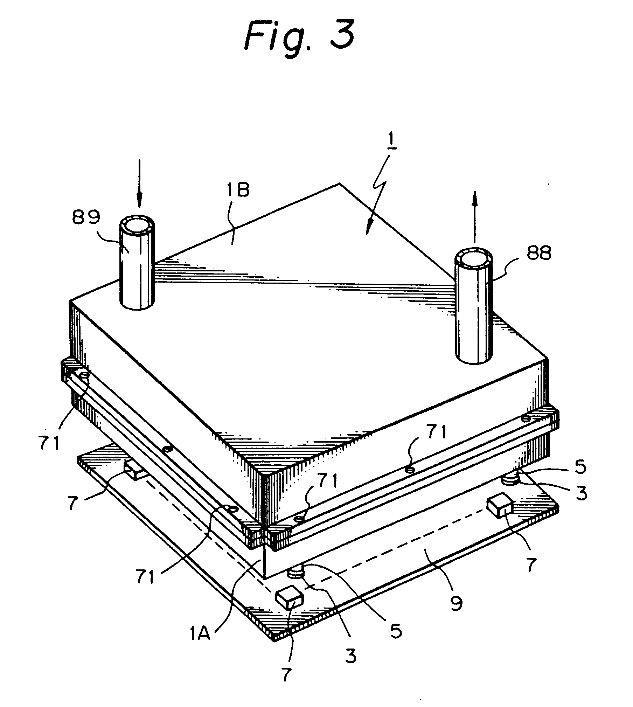

Figure 3 shows one example of a perspective appearance of a cooling unit having an assembly of cooling modules such as are shown in Fig. 2. In Fig. 3, the inlet pipe 89 and the outlet pipe 88 are in different positions from those shown in Fig. 2. The cover 1B can be detached from the lower half 1A by removing the bolts 71.

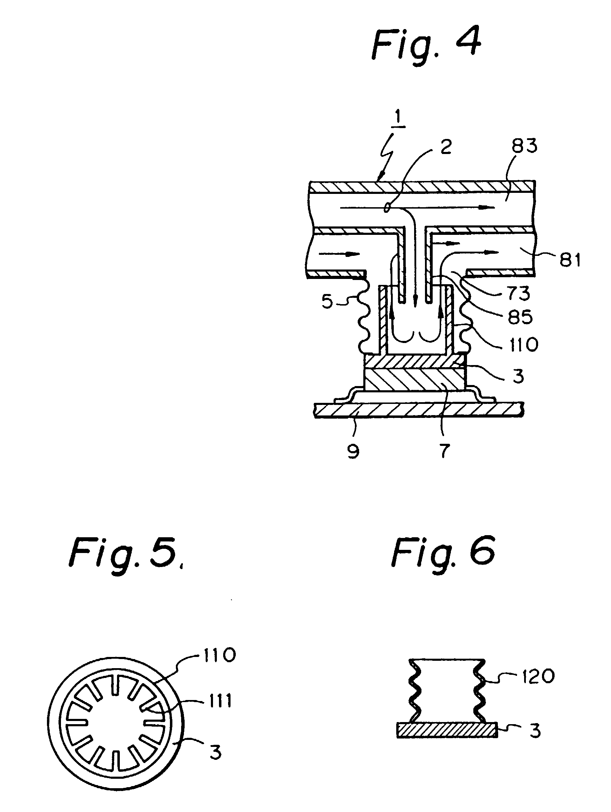

To increase the cooling effect, according to the present invention, a means for increasing the contacting surface area between the coolant 2 and the heat transfer plate 3 is provided, as shown in Figs. 4 to 9.

In Fig. 4, the plate 3 is provided with a substantially cylindrical tube 110 integral therewith into which the lower end, i.e. the outlet end, of the nozzle 85 is inserted.

The tube 110 is located in the bellows 5 and increases the effective contacting surface area between the plate 3 and the coolant 2. It will be appreciated from the drawings that a major portion of the upper main face of the heat transfer plate 3 is located within the tube 110. The coolant ejected from the nozzle 85 comes into collision with the plate 3 and flows up along the tubular wall of the tube 110, removing the heat from the plate 3, as shown by arrows in Fig. 4. The tube 110 can be provided, on its inner periphery, with heat transfer fins 111, as shown in Fig. 5. As is well known, such fins 111 will increase the heat transmission efficiency between the tube 110 and the coolant 2. The fins 111 preferably extend radially as shown in Fig. 5, so that those fins 111 do not substantially interrupt the smooth flow of the coolant 2.

In a variant shown in Fig. 6, the tube 110 in Fig. 4 is replaced with a cylindrical tube 120 having a corrugated cylindrical wall. With the variant shown in Fig. 6, the heat transmission effect can be increased in comparison with the plain cylindrical wall as shown in Fig. 4.

The tube 110 or 120, which has a height substantially equal to the length of the bellows 5, also serves to shield the bellows, which is usually made of a thin metal plate, from contact with the main stream of coolant 2, thereby aiding in the prevention of possible corrosion of or damage to the bellows.

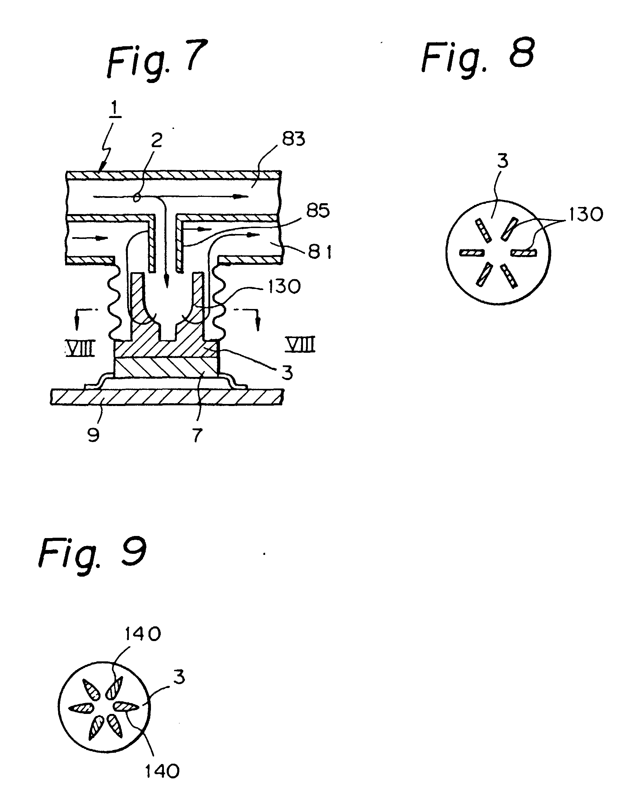

Figures 7 and 8 show another form of tubular construction provided on the plate 3. In Figs. 7 and 8, a plurality of plate-like fins 130 are provided on the plate 3. The fins 130 are discontinuously arranged along a circle and extend radially when viewed in section as in Fig. 8. Since the fins 130 are spaced from one another preferably equidistantly, the resistance against the flow of the coolant 2 can be decreased in comparison with the continuous cylindrical wall as shown in Fig. 4.

In Fig. 9, which shows a variant 140 of the fins 130 shown in Fig. 8, the fins 140 have a streamlined shape in section, from the viewpoint of aerodynamics, to decrease the resistance of the fins 140 to the smooth flow of the coolant 2.

The cooling apparatus can be used upside down, so that the coolant is ejected upward from the nozzles 85 towards the heat transfer plates 3 located above the nozzles 85.

## Claims

1. A cooling module, in combination with an electronic circuit component (7) mounted on a printed circuit board (9), including:
a heat transfer plate (3), for conducting heat from the electronic circuit component (7) to a coolant (2) in the module, having a substantially cylindrical tubular construction (110; 120; 130; 140) provided thereon and projecting axially from the main face thereof;
resilient biasing means (5) connected to the heat transfer plate (3) and serving to urge that plate towards the circuit component (7), the substantially cylindrical tubular construction (110; 120; 130; 140) extending within the resilient biasing means (5); and
passage means (1) for containing the coolant (2) which flows in contact with a main face of the heat transfer plate (3),
**characterised in that** the passage means (1) comprises a nozzle (85), the outlet of which is within the substantially cylindrical tubular construction (110; 120; 130; 140) and directed towards the main face of the heat transfer plate (3) such that, when the module is in use, the coolant (2) flows to a major portion of the main face by way of the tubular construction (110; 120; 130; 140).

2. A cooling module as claimed in claim 1, wherein the tubular construction is a substantially cylindrical tube (110; 120).

3. A cooling module as claimed in claim 2, wherein the substantially cylindrical tube is made of corrugated material (120).

4. A cooling module as claimed in claim 2 or 3, wherein the substantially cylindrical tube (110) is provided with internally projecting heat-transfer fins (111).

5. A cooling module as claimed in claim 1, wherein the substantially cylindrical tubular construction is formed of a plurality of heat transfer fins (130, 140) which are spaced apart from one another around the axis of that construction.

## Patentansprüche

1. Kühlmodul in Kombination mit einer elektronischen Schaltkreiskomponente (7), die an einer gedruckten Leiterplatte (9) angebracht ist, mit:
einer Wärmeübertragungsplatte (3), zum Führen von Wärme von der elektronischen Schaltkreiskomponente (7) aus zu einem Kühlmittel (2) in dem Modul hin, die eine im wesentlichen zylindrische, rohrförmige Konstruktion (110; 120; 130; 140) aufweist, die daran vorgesehen ist und von der Hauptfläche von dieser aus axial vorsteht;
einem nachgiebigen Vorspannmittel (5), das mit der Wärmeübertragungsplatte (3) verbunden ist und dazu dient, diese Platte in Richtung zu der Schaltkreiskomponente (7) hin zu drücken, wobei sich die im wesentlichen zylindrische, rohrförmige Konstruktion (110; 120; 130; 140) innerhalb des elastischen Vorspannmittels (5) erstreckt; und
einem Kanalmittel (1) zur Aufnahme des Kühlmittels (2), das in Berührung mit einer Hauptfläche der Wärmeübertragungsplatte (3) strömt,
**dadurch gekennzeichnet, daß** das Kanalmittel (1) eine Düse (85) umfaßt, deren Auslaß sich innerhalb der im wesentlichen zylindrischen, rohrförmigen Konstruktion (110; 120; 130; 140) befindet und in Richtung zu der Hauptfläche der Wärmeübertragungsplatte (3) hin ausgerichtet ist, dies derart, daß dann, wenn das Modul in Benutzung steht, das Kühlmittel (2) zu einem größeren Bereich der Hauptfläche mittels der rohrförmigen Konstruktion (110; 120; 130, 140) strömt.

2. Kühlmodul nach Anspruch 1, wobei die rohrförmige Konstruktion ein im wesentlichen zylindrisches Röhrchen (110, 120) ist.

3. Kühlmodul nach Anspruch 2, wobei das im wesentlichen zylindrische Röhrchen aus einem gewellten Material (120) hergestellt ist.

4. Kühlmodul nach Anspruch 2 oder 3, wobei das im wesentlichen zylindrische Röhrchen (110) mit innenseitig vorstehenden Wärmeübertragungsrippen (111) ausgestattet ist.

5. Kühlmodul nach Anspruch 1, wobei die im wesentlichen zylindrische, rohrförmige Konstruktion aus einer Vielzahl von Wärmeübertragungsrippen (130, 140) gebildet ist, die um die Achse dieser Konstruktion herum voneinander beabstandet angeordnet sind.

## Revendications

1. Module de refroidissement combiné à un composant (7) de circuit électronique monté sur une carte de circuit imprimé (9), comprenant :
une plaque (3) de transfert de chaleur destinée à conduire la chaleur du composant (7) de circuit électronique à un fluide de refroidissement (2) placé dans le module, ayant une construction tubulaire pratiquement cylindrique (110 ; 120 ; 130 ; 140) placée sur la plaque et dépassant axialement de la face principale de celle-ci,
un dispositif élastique de rappel (5) raccordé à la plaque (3) de transfert de chaleur et destiné à rappeler cette plaque vers le composant (7) du circuit, la construction tubulaire pratiquement cylindrique (110 ; 120 ; 130 ; 140) s'étendant dans le dispositif élastique de rappel (5), et
un dispositif (1) à passage destiné à contenir le fluide de refroidissement (2) qui s'écoule au contact d'une face principale de la plaque (3) de transfert de chaleur,
caractérisé en ce que le dispositif à passage (1) comporte une buse (85) dont la sortie se trouve à l'intérieur de la construction tubulaire pratiquement cylindrique (110 ; 120 ; 130 ; 140) et dirigée vers la face principale de la plaque (3) de transfert de chaleur afin que, lorsque le module est utilisé, le fluide de refroidissement (2) s'écoule vers une partie principale de la face principale par la construction tubulaire (110 ; 120 ; 130 ; 140).

2. Module de refroidissement selon la revendication 1, dans lequel la construction tubulaire est un tube pratiquement cylindrique (110 ; 120).

3. Module de refroidissement selon la revendication 2, dans lequel le tube pratiquement cylindrique est formé d'un matériau ondulé (120).

4. Module de refroidissement selon la revendication 2 ou 3, dans lequel le tube pratiquement cylindrique (110) a des ailettes (111) de transfert de chaleur qui dépassent à l'intérieur.

5. Module de refroidissement selon la revendication 1, dans lequel la construction tubulaire pratiquement cylindrique est formée par plusieurs ailettes (130, 140) de transfert de chaleur qui sont espacées les unes des autres autour de l'axe de cette construction.
